# EUROPÄISCHE PATENTANMELDUNG

(11) **EP 1 189 349 A1**
(43) Veröffentlichungstag der Anmeldung: **20.03.2002**
(21) Anmeldenummer: 00810837.5
(22) Anmeldetag: 15.09.2000
(51) Int. Cl.: H03K 17/12

(54) **Parallelschaltung einer Mehrzahl von IGBTs**

(71) Anmelder: ABB RESEARCH LTD., 8050 Zürich (CH)
(72) Erfinder: Jörg, Pieder, 7013 Domat/Ems (CH)
(74) Vertreter: ABB Patent Attorneys

(57) **Zusammenfassung**

Bei einer Parallelschaltung (10) einer Mehrzahl von IGBTs (T1,..,T3) hoher Leistung, welche jeweils durch eine eigene Gate-Ansteuerschaltung (GD1,..,GD3) angesteuert werden, wobei jede der Gate-Ansteuerschaltungen (GD1,..,GD3) an ihrem Ausgang einen p-Kanal-MOSFET (M1, M3, M5) und einen n-Kanal-MOS-FET (M2, M4, M6) in einer Push-Pull-Anordnung aufweist und die Ausgänge der Gate-Ansteuerschaltungen (GD1,..,GD3) mit den Gates der IGBTs (T1,..,T3) jeweils über einen Gatewiderstand (R1,..,R3) verbunden sind, wird eine Parallelschaltung von mehr als zwei Gate-Ansteuerschaltungen dadurch ermöglicht, dass die Ausgänge der Gate-Ansteuerschaltungen (GD1,..,GD3) über eine Verbindungsleitung (11) untereinander verbunden sind, und dass die MOSFETs (M1,..,M6) der Gate-Ansteuerschaltungen (GD1,..,GD3) jeweils über eine Konstantstromquelle (CS1,..,CS6) an eine positive bzw. negative Versorgungsklemme (P1,..,P3 bzw. N1,..,N3) angeschlossen sind.

## Beschreibung

### TECHNISCHES GEBIET

Die vorliegende Erfindung bezieht sich auf das Gebiet der Leistungselektronik. Sie betrifft eine Parallelschaltung einer Mehrzahl von IGBTs gemäss dem Oberbegriff des Anspruchs 1.

### STAND DER TECHNIK

Es sind seit längerem leistungselektronische Halbleiter-Module auf dem Markt, in denen bis zu sechs Hochleistungs-IGBTs mit entsprechenden antiparallelen Dioden so angeordnet und untereinander verbunden sind, dass sie entweder die einzelnen Arme einer 3-phasigen Stromrichterbrücke bilden können oder durch Parallelschaltung zu einem einzigen Phasenarm mit 3-facher Strombelastbarkeit kombiniert werden können. Derartige Module werden von der Anmelderin unter der allgemeinen Typenbezeichnung LoPak5 angeboten und haben beispielsweise eine Kollektor-Emitter-Spannung V_{CE} von 1200 V und einen Kollektorstrom I_{C} von 300 A (siehe das Datenblatt 5SYA1528 der Firma ABB Semiconductors AG zum Modultyp 5SNS0300U120100 vom 1. Juli 2000).

Die Parallelschaltung derartiger Hochleistungs-IGBTs auf der Leistungsseite (d.h. durch Parallelschaltung der Kollektor-Emitterstrecken der einzelnen IGBTs) wirft verschiedene Probleme auf:

Werden die IGBTs mit ihren zugehörigen Gate-Ansteuerschaltungen ("Gate Drives") ohne weitere Massnahmen nur auf der Leistungsseite parallel geschaltet, kann es durch unterschiedliche Verzögerungen in den Gate-Ansteuerschaltungen beim Schalten der IGBTs dynamisch zu einer erheblichen Ungleichverteilung der Ströme auf die einzelnen IGBTs kommen. Da die einzelnen Gates der IGBTs nicht miteinander verbunden sind, hilft auch nicht das positive Transistorverhalten der IGBTs.

Werden die Gates der IGBTs ebenfalls parallel geschaltet, haben die IGBTs wegen ihres grundsätzlichen Transistorverhaltens natürlicherweise die Tendenz, die Ströme statisch unter sich gleich aufzuteilen: Identische Transistoren haben identische I_{CE}/V_{CE}-Charakteristiken und sie müssen - da sie dasselbe V_{CE} und dieselbe Gatespannung haben - auch denselben Kollektor-Emitter-Strom I_{CE} ziehen. Dynamisch können sich die Ströme jedoch erheblich unterscheiden. Die absoluten Werte der Gatewiderstände ebenso wie das Verhältnis von einzelnen und gemeinsamen Widerständen im Modul beeinflussen die Balance zwischen den Strömen.

Ueblicherweise ist die Ausgangsstufe einer für derartige IGBTs eingesetzten Gate-Ansteuerschaltung ein mit zwei MOSFETs (p-Kanal- und n-Kanal-MOSFET) aufgebaute Push-Pull-Stufe. Wenn zwei Gate-Ansteuerschaltungen parallel geschaltet werden, muss sichergestellt sein, dass die eine Gate-Ansteuerschaltung nicht auf die andere durchschlägt und dass die eine Gate-Ansteuerschaltung nicht die andere "auflädt". Die einfachste Lösung besteht darin, zur Entkopplung der Gate-Ansteuerschaltungen individuelle Gatewiderstände zu verwenden. Eine solche Lösung ist jedoch nur für zwei parallel geschaltete Gate-Ansteuerschaltungen realisierbar.

### DARSTELLUNG DER ERFINDUNG

Es ist daher Aufgabe der Erfindung, eine Parallelschaltung von Hochleistungs-IGBTs anzugeben, bei der mehr als zwei Gate-Ansteuerschaltungen parallel geschaltet sind.

Die Aufgabe wird durch die Gesamtheit der Merkmale des Anspruchs 1 gelöst. Der Kern der Erfindung besteht darin, die MOSFETs in den Ausgangsstufen der Gate-Ansteuerschaltungen jeweils über eine Konstantstromquelle an eine positive bzw. negative Versorgungsklemme anzuschliessen und die Ausgänge der Gate-Ansteuerschaltungen über eine Verbindungsleitung untereinander zu verbinden. Die Konstantstromquellen sind dabei als "schwache" Konstantstromquellen ausgebildet und werden in an sich bekannter Weise aus einem Transistor bzw. MOSFET und Dioden und/oder Widerständen aufgebaut.

Um die Stromversorgungen der Gate-Ansteuerschaltungen zumindest gleichmässig zu belasten, ist es von Vorteil, wenn die positiven bzw. negativen Versorgungsklemmen der Gate-Ansteuerschaltungen jeweils untereinander durch Verbindungsleitungen verbunden sind

### KURZE ERLÄUTERUNG DER FIGUREN

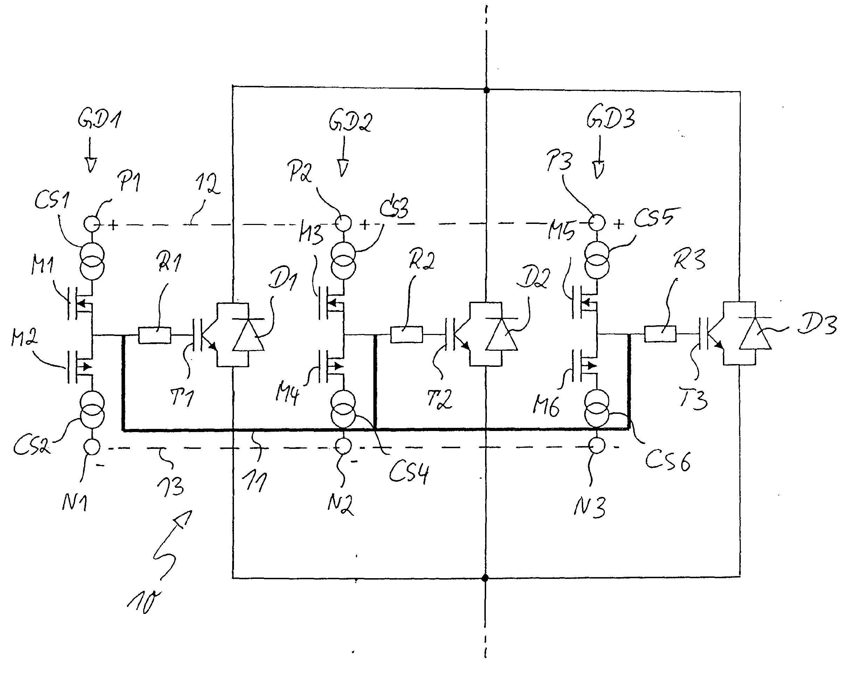

Die Erfindung soll nachfolgend anhand eines Ausführungsbeispiels im Zusammenhang mit der Zeichnung näher erläutert werden. Die einzige Figur zeigt das Schaltungsschema eines bevorzugten Ausführungsbeispiels einer Parallelschaltung nach der Erfindung.

### WEGE ZUR AUSFÜHRUNG DER ERFINDUNG

In der Figur ist eine Parallelschaltung von drei IGBTs T1,..,T3 gemäss einem bevorzugten Ausführungsbeispiel der Erfindung dargestellt. Die IGBTs (Insulated Gate Bipolar Transistors) T1,..,T3 mit ihren antiparallelen Dioden D1,..,D3 können beispielsweise Teil eines Leistungshalbleitermoduls sein, wie es in der Einleitung erwähnt worden ist, und wie es zur Bildung von gesteuerten Stromrichterbrücken eingesetzt wird. Die IGBTs sind auf der Leistungsseite parallel geschaltet und bilden so beispielsweise einen Zweig einer Stromrichterbrücke mit der 3-fachen Strombelastbarkeit. Jeder der IGBTs T1,..,T3 wird über einen Gatewiderstand R1,..,R3 von einer zugehörigen Gate-Ansteuerschaltung ("Gate Drive") GD1,..,GD3 angesteuert, von welcher der Einfachheit halber nur die mit MOSFETs M1,..,M6 bestückte Ausgangsstufe dargestellt ist.

Bei jeder der Gate-Ansteuerschaltungen GD1,..,GD3 sind in der Ausgangsstufe ein p-Kanal-MOSFET (M1, M3, M5) und eine n-Kanal-MOSFET (M2, M4, M6) in einer Push-Pull-Anordnung vorgesehen. Jeder der MOSFETs M1,..,M6 ist über eine zugehörige Konstantstromquelle CS1,..,CS6 an eine positive bzw. negative Versorgungsklemme P1,..,P3 bzw. N1,..,N3 angeschlossen. Die Konstantstromquellen CS1,..,CS6 sind als "schwache" Konstantstromquellen aus einem Transistor bzw. MOSFET und Dioden und/oder Widerständen aufgebaut.

Die Ausgänge der Gate-Ansteuerschaltungen GD1,..,GD3, d.h. die Verbindungspunkte zwischen den MOSFET-Paaren in der Ausgangsstufe, sind über eine gemeinsame erste Verbindungsleitung 11 untereinander verbunden und damit parallel geschaltet. Die positiven Versorgungsklemmen P1,..,P3 sind durch eine zweite Verbindungsleitung 12 und die negativen Versorgungsklemmen N1,..,N3 durch eine dritte Verbindungsleitung 13 untereinander verbunden.

Obgleich das Problem der Ungleichverteilung der Belastung zwischen den Gate-Ansteuerschaltungen GD1,..,GD3 bleibt, d.h., die zuerst ansteuernde Gate-Ansteuerschaltung immer am stärksten belastet wird, wird die Belastung durch den erfindungsgemässen Schaltungsaufbau auf einen vorbestimmten Wert begrenzt. Gleichzeitig werden die Stromversorgungen der Gate-Ansteuerschaltungen GD1 ,..,GD3 durch die Verbindung der Versorgungsklemmen P1,..,P3 und N1,..,N3 gleichmässig belastet.

### BEZUGSZEICHENLISTE

- 10: Parallelschaltung
- 11: Verbindungsleitung (Gate-Ansteuerschaltung)
- 12,13: Verbindungsleitung (Versorgungsklemmen)
- CS1,..,CS6: Konstantstromquelle
- D1,..,D3: Diode
- GD1,..,GD3: Gate-Ansteuerschaltung (Gate Drive)
- M1,..,M6: MOSFET-Transistor
- N1,..,N3: negative Versorgungsklemme
- P1,..,P3: positive Versorgungsklemme
- R1,..,R3: Gatewiderstand
- T1,..,T3: IGBT

## Patentansprüche

1. Parallelschaltung (10) einer Mehrzahl von IGBTs (T1,..,T3) hoher Leistung, welche jeweils durch eine eigene Gate-Ansteuerschaltung (GD1,..,GD3) angesteuert werden, wobei jede der Gate-Ansteuerschaltungen (GD1,..,GD3) an ihrem Ausgang einen p-Kanal-MOSFET (M1, M3, M5) und einen n-Kanal-MOSFET (M2, M4, M6) in einer Push-Pull-Anordnung aufweist und die Ausgänge der Gate-Ansteuerschaltungen (GD1,..,GD3) mit den Gates der IGBTs (T1,..,T3) jeweils über einen Gatewiderstand (R1,..,R3) verbunden sind, **dadurch gekennzeichnet, dass** die Ausgänge der Gate-Ansteuerschaltungen (GD1,..,GD3) über eine Verbindungsleitung (11) untereinander verbunden sind, und dass die MOSFETs (M1,..,M6) der Gate-Ansteuerschaltungen (GD1,..,GD3) jeweils über eine Konstantstromquelle (CS1,..,CS6) an eine positive bzw. negative Versorgungsklemme (P1,..,P3 bzw. N1,..,N3) angeschlossen sind.

2. Parallelschaltung nach Anspruch 1, **dadurch gekennzeichnet, dass** die Konstantstromquellen (CS1,..,CS6) aus einem Transistor bzw. MOSFET und Dioden und/oder Widerständen aufgebaut ist.

3. Parallelschaltung nach einem der Ansprüche 1 und 2, **dadurch gekennzeichnet, dass** die positiven bzw. negativen Versorgungsklemmen (P1,..,P3 bzw. N1,..,N3) der Gate-Ansteuerschaltungen (GD1,..,GD3) jeweils untereinander durch Verbindungsleitungen (12 bzw. 13) verbunden sind.
